# FASCICULE DE BREVET EUROPEEN

(11) **EP 3 579 233 B1**
(45) Date de publication et mention de la délivrance du brevet: **27.01.2021**
(21) Numéro de dépôt: 18175744.4
(22) Date de dépôt: 04.06.2018
(51) Int. Cl.: G11C 5/14, H02M 3/07

(54) **CELLULE ELEMENTAIRE ET POMPES DE CHARGES COMPRENANT UNE TELLE CELLULE ELEMENTAIRE**
ELEMENTARZELLE UND LADEPUMPEN, DIE EINE SOLCHE ELEMENTARZELLE UMFASSEN
BASIC CELL AND PRIMING PUMPS COMPRISING SUCH A BASIC CELL

(43) Date de publication de la demande: 11.12.2019
(73) Titulaire: EM Microelectronic-Marin SA, 2074 Marin (CH)
(72) Inventeur: Coustans, Mathieu, 1020 Renens (CH); Plavec, Lubomir, 61200 Brno (CZ); Dellea, Mario, 2300 La Chaux-de-Fonds (CH)
(74) Mandataire: ICB SA

(56) Documents cités:
- JP-A- 2010 207 092
- US-A1- 2004 217 803
- NA YAN ET AL: "An Improved Charge Pump with High Efficiency for Low Voltage Operations", ASIC, 2005. ASICON 2005. 6TH INTERNATIONAL CONFERENCE ON SHANGHAI, CHINA 24-27 OCT. 2005, PISCATAWAY, NJ, USA,IEEE, PISCATAWAY, NJ, USA, vol. 2, 24 octobre 2005 (2005-10-24), pages 584-587, XP010904501, DOI: 10.1109/ICASIC.2005.1611396 ISBN: 978-0-7803-9210-6
- NA LI ET AL: "High efficiency four-phase All PMOS charge pump without body effects", COMMUNICATIONS, CIRCUITS AND SYSTEMS, 2008. ICCCAS 2008. INTERNATIONAL CONFERENCE ON, IEEE, PISCATAWAY, NJ, USA, 25 mai 2008 (2008-05-25), pages 1083-1087, XP031353106, ISBN: 978-1-4244-2063-6

## Description

### DOMAINE TECHNIQUE DE L'INVENTION

L'invention concerne le domaine des circuits intégrés, et plus particulièrement les circuits de pompe de charges qui, à partir d'une source de tension primaire, génère une tension secondaire plus importante en valeur absolue.

### ETAT DE LA TECHNIQUE

De nombreux systèmes électroniques nécessitent plus d'un seul niveau de tension d'alimentation pour fonctionner. Par exemple, certains types de circuits de mémoire non volatile, qui peuvent typiquement utiliser une seule alimentation de 0.9V comme source primaire d'alimentation, nécessitent souvent aussi des tensions d'alimentation plus élevées, par exemple, de 10V à 15V pour la programmation ou l'effacement de fonctions. De même, les circuits développés pour être utilisés dans les écrans à cristaux liquides, les amplificateurs de puissance à radiofréquence et, dans une certaine mesure, les circuits d'amorçage (bootstrap en terminologie anglaise) à condensateurs commutés, nécessitent souvent des tensions d'alimentation plus hautes que la tension primaire pour fonctionner. Il est donc indispensable de prévoir dans les circuits intégrés des circuits élévateurs de tension pour générer la tension d'alimentation requise à partir de la tension primaire d'alimentation du circuit intégré, pour éviter d'avoir recours à des alimentations externes supplémentaires. Pour ce faire, on a mis au point des circuits de multiplication de tension ou de pompe de charges qui génèrent les tensions plus élevées à partir de la tension d'alimentation primaire.

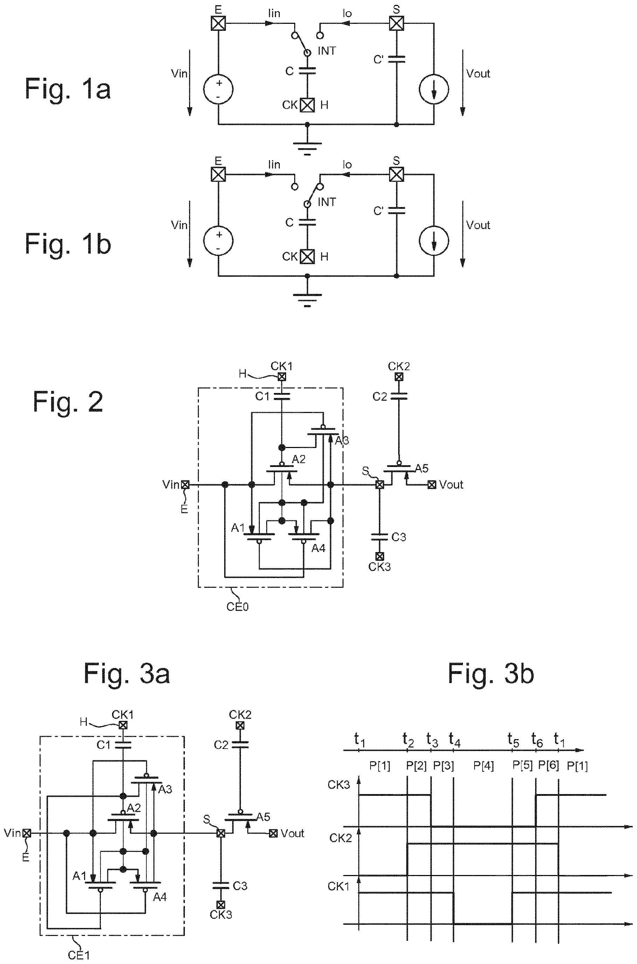

Les figures 1a, 1b schématisent le fonctionnement d'une cellule idéale de pompe de charges, où la tension de sortie Vout est sensiblement égale à deux fois la tension d'entrée Vin. La cellule comprend :
- une borne d'entrée E et une borne de sortie S, la tension Vout étant disponible sur la borne de sortie lorsque la tension d'entrée Vin est appliquée sur la borne d'entrée, une borne d'horloge H pour recevoir un signal d'horloge CK,
- un condensateur C dit de pompage comprenant une première borne couplée à la borne d'horloge H, et une deuxième borne,
- un condensateur C' comprenant une première borne couplée à une masse de la cellule et une deuxième borne couplée à la borne de sortie S, la tension Vout étant disponible entre les deux bornes du condensateur C',
- un commutateur INT agencé pour coupler la deuxième borne du condensateur C alternativement à la borne d'entrée E ou à la borne de sortie S en fonction du signal d'horloge CK.

Le fonctionnement général de la cellule de pompe de charges est le suivant. Le signal d'horloge est de manière classique un signal rectangulaire, périodique, qui alterne entre un potentiel nul correspondant à la masse du circuit et un potentiel haut généralement égal à un potentiel d'alimentation primaire Vdd du circuit. Au cours d'une première phase (figure 1a), lorsque le signal d'horloge CK est nul, la première borne du condensateur C est à la masse et le commutateur INT relie la deuxième borne du condensateur C à la borne d'entrée E de la cellule sur laquelle est appliquée la tension Vin. Le condensateur C se charge avec un courant Iin, jusqu'à ce que la deuxième borne du condensateur C soit au potentiel Vin. Au cours d'une deuxième phase (figure 1b), le signal d'horloge CK passe du potentiel nul au potentiel Vdd et le commutateur INT bascule pour relier la deuxième borne du condensateur C à la deuxième borne du condensateur C'. Le potentiel sur la première borne du condensateur C passant de 0 à Vdd, le potentiel sur la deuxième borne du condensateur C est repoussé de Vin à Vin+Vdd. Le potentiel sur la deuxième borne du condensateur C étant supérieur au potentiel sur la deuxième borne du deuxième condensateur C', le condensateur C se décharge dans le condensateur C' en créant un courant Io de sorte que le potentiel sur la borne de sortie S grimpe. La première phase et la deuxième phase sont répétées au fil des changements d'état du signal d'horloge de sorte que, en régime établi et à partir d'un potentiel d'entrée Vin, un potentiel Vin+Vdd supérieur à Vin est disponible en sortie de la cellule. En choisissant Vin = Vdd, le potentiel en sortie de la cellule est le double du potentiel appliqué en entrée.

On peut citer par exemple une réalisation d'une pompe de charges décrite dans le document de R. Pelliconi, D. Iezzi, A. Baroni, M. Pasotti, and P. L. Rolandi, "Power efficient charge pump in deep submicron standard CMOS technology," IEEE J. Solid-State Circuits, vol. 38, no. 6, pp. 1068-1071, 2003. Cependant, cela nécessite des caissons isolés, car le circuit électrique n'est pas réalisé avec des transistors d'un même type de conductivité, ce qui constitue un inconvénient.

Une implémentation possible d'une demi-cellule de pompe de charges (ou demi-cellule PDC) a été proposée dans le document N. Li, Z. Huan, M. Jiang and Y. Inoue, « High efficiency four-phase all PMOS charge pump without body effect », 2008 Int. Conf. Commun. Circuits Syst. Proceedings, ICCCAS 2008, n°1, pp1083-1087, 2008. Ce document propose une demi-cellule PDC conforme à la figure 2, comprenant une cellule élémentaire CE0 de pompage comprenant :
- une borne d'entrée E agencée pour recevoir une tension d'entrée Vin, une borne d'horloge H agencée pour recevoir un premier signal d'horloge CK1 et une borne de sortie S,
- un premier condensateur C1 comprenant une première borne connectée à la borne d'horloge H et une deuxième borne,
- un premier transistor A1 comprenant une première borne source/drain couplée à la borne d'entrée E, une deuxième borne source/drain et une borne de grille,
- un deuxième transistor A2 comprenant une première borne source/drain couplée à la borne de sortie S de la cellule élémentaire, une deuxième borne source/drain couplée à la borne d'entrée E et une borne de grille couplée à la deuxième borne du premier condensateur C1,
- un troisième transistor A3 comprenant une première borne source/drain couplée à la première borne source/drain du deuxième transistor A2, une deuxième borne source/drain couplée à la borne de grille du deuxième transistor A2 et une borne de grille couplée à la borne d'entrée E, et
- un quatrième transistor A4 comprenant une première borne source/drain couplée à la deuxième borne source/drain du premier transistor A1, une deuxième borne source/drain couplée à la première borne source/drain des deuxième A2 et troisième A3 transistors et à la borne de grille du premier transistor A1, et une borne de grille couplée à la borne d'entrée E

Une telle cellule élémentaire est également décrite par le document NA YAN ET AL: "An Improved Charge Pump with High Efficiency for Low Voltage Operations",ASIC, 2005. ASICON 2005. 6TH INTERNATIONAL CONFERENCE ON SHANGHAI, vol. 2, pages 584-587.

Outre la cellule élémentaire CE0, la demi-cellule PDC de la figure 2 comprend également :
- un deuxième condensateur C2 comprenant une première borne destinée à recevoir un deuxième signal d'horloge CK2 et une deuxième borne,
- un troisième condensateur C3 comprenant une première borne destinée à recevoir un troisième signal d'horloge CK3 et une deuxième borne couplée à la borne de sortie S de la cellule élémentaire CE1,
- un cinquième transistor A5 comprenant une première borne source/drain couplée à une borne de sortie Vout de la demi-cellule PDC, une deuxième borne source/drain couplée à la borne de sortie S de la cellule élémentaire CE0 et une borne de grille couplée à la deuxième borne du deuxième condensateur C2.

Par rapport à des structures de cellules antérieures, la structure de la demi-cellule PDC de la figure 2 présente l'avantage d'utiliser uniquement des transistors de type PMOS, et non une combinaison de transistors NMOS et PMOS. Elle peut ainsi être réalisée directement sur un substrat de type N, sans qu'il soit nécessaire de réaliser un ou plusieurs caissons N sur un substrat P, comme c'est le cas habituellement pour des circuits comprenant des transistors NMOS et des transistors PMOS. La réalisation de la cellule est ainsi grandement simplifiée.

Néanmoins, le fonctionnement de la demi-cellule PDC de la figure 2 n'est pas optimal, en particulier le changement d'état du transistor A1 n'est pas parfait. En effet, lorsque le troisième signal d'horloge CK3 chute de Vdd à zéro, la tension V1 entre la borne de sortie S et la masse chute de Vout à Vout-Vdd < Vin de sorte que les transistors A3 et A4 se bloquent. Le transistor A1 est supposé devenir passant, mais il le devient seulement partiellement de sorte que le potentiel de caisson du transistor A2 ne peut pas descendre jusqu'à Vin. Le seuil de conduction du transistor A2 va être plus haut, à cause de l'effet de caisson, le transistor A2 commute difficilement de sorte que le transfert de charges entre la borne d'entrée et la borne de sortie n'est pas efficace.

### RÉSUMÉ DE L'INVENTION

L'invention a pour objet de fournir une solution alternative à la solution connue de la figure 2, où le transfert de charges entre la borne d'entrée et la borne de sortie de la cellule élémentaire de pompage est plus efficace.

A cet effet, l'invention propose une nouvelle cellule élémentaire de pompage, par ailleurs conforme au préambule de la revendication 1 et en partie à la cellule élémentaire de la figure 2, caractérisée en ce que la borne de grille du premier transistor est connectée maintenant directement à la borne de grille du deuxième transistor de la cellule élémentaire, en lieu et place d'être connectée à la borne de sortie de la cellule élémentaire comme décrit à la figure 2. Comme on le verra mieux plus loin, cette nouvelle connexion de la grille du premier transistor permet, lors d'un changement d'état du premier signal d'horloge et/ou du troisième signal d'horloge, de rendre plus passant le premier transistor pour un meilleur transfert de charges entre la borne d'entrée de la cellule élémentaire et le caisson du deuxième transistor. Il s'ensuit une meilleure maîtrise de la tension source/caisson du deuxième transistor et en conséquence un seuil de changement d'état mieux maîtrisé pour le deuxième transistor. L'efficacité globale de la cellule élémentaire de la pompe de charges est ainsi améliorée.

Les transistors de la cellule élémentaire sont préférentiellement de même type, et de préférence de type P. L'utilisation de transistors de type P uniquement, présente l'avantage de ne pas nécessiter l'utilisation de technologie nécessitant un caisson de dopage du semi-conducteur dit triple caisson (« triple well » en terminologie anglaise) afin d'isoler les transistors NMOS du substrat. Chaque transistor de la cellule élémentaire comprend également une borne de caisson, et les bornes de caisson de tous les transistors de la cellule élémentaire sont couplées ensemble, de préférence à la deuxième borne source/drain du premier transistor.

La nouvelle cellule élémentaire de pompage peut être avantageusement utilisée pour réaliser une demi-cellule de pompe de charges (ou demi-cellule PDC) comprenant :
- une cellule élémentaire selon l'invention et telle que décrite ci-dessus, comprenant une borne d'horloge destinée à recevoir un premier signal d'horloge et une borne de sortie,
- un deuxième condensateur comprenant une première borne destinée à recevoir un deuxième signal d'horloge et une deuxième borne,
- un troisième condensateur comprenant une première borne destinée à recevoir un troisième signal d'horloge et une deuxième borne couplée à la borne de sortie de la cellule élémentaire,
- un cinquième transistor comprenant une première borne source/drain couplée à une borne de sortie de la demi-cellule PDC, une deuxième borne source/drain couplée à la borne de sortie de la cellule élémentaire et une borne de grille couplée à la deuxième borne du deuxième condensateur.

La demi-cellule PDC selon l'invention fonctionne globalement de la manière suivante. Le deuxième transistor et le cinquième transistor ont ensemble le même rôle que le commutateur INT, et le troisième condensateur a une fonction de pompage. Lorsque le deuxième transistor est passant, le troisième condensateur est relié à la borne d'entrée de la cellule élémentaire et se charge. Lorsque le cinquième transistor est passant, le troisième condensateur se décharge en alimentant un circuit aval relié à la borne de sortie de la demi-cellule PDC.

Le troisième transistor est passant lorsque le deuxième transistor est passant ou lorsque le cinquième transistor est passant. Le troisième transistor a une fonction de transistor d'étage élévateur (boost-stage en terminologie anglaise). Il améliore le transfert de charges lors du chargement et du déchargement du troisième condensateur.

Le premier transistor et le quatrième transistor ont pour principale fonction de fixer le potentiel des caissons des transistors de la cellule élémentaire, soit au potentiel appliqué sur la borne d'entrée de la cellule élémentaire lorsque le premier transistor est passant, soit au potentiel disponible sur la borne de sortie de la cellule élémentaire lorsque le quatrième transistor est passant. Le premier transistor, et en particulier sa nouvelle connexion de grille selon l'invention, et le quatrième transistor permettent ainsi de maîtriser au mieux le seuil et les changements d'état du deuxième transistor, pour un transfert de charges plus efficace entre la borne d'entrée et la borne de sortie de la cellule élémentaire.

La nouvelle cellule élémentaire de pompage peut également être avantageusement utilisée pour réaliser une pompe de charges de type Dickson, une pompe de charges de type à couplage croisé ou un circuit d'amorçage (bootstrap en terminologie anglaise), comme on le verra mieux par la suite.

### BRÈVE DESCRIPTION DES FIGURES

L'invention sera décrite ci-après de manière plus détaillée à l'aide des dessins annexés, donnés à titre d'exemples nullement limitatifs, dans lesquels :
- les figures 1a et 1b déjà citées schématisent les deux phases de fonctionnement d'une pompe de charges,
- la figure 2 déjà citée montre une structure connue de pompe de charges,
- la figure 3a montre un schéma d'une demi-cellule de pompe de charges comprenant une cellule élémentaire selon l'invention,
- la figure 3b montre un exemple de signaux d'horloge susceptibles d'être utilisés pour commander la demi-cellule de pompe de charges de la figure 3a,
- la figure 3c schématise le fonctionnement dans le temps de la demi-cellule de pompe de charges de la figure 3a commandée par les signaux d'horloge de la figure 3b,
- la figure 4 montre un schéma d'une pompe de charges de type Dickson comprenant des cellules élémentaires selon l'invention,
- la figure 5 montre un schéma d'une pompe de charges de type à couplage croisé comprenant des cellules élémentaires selon l'invention.

### DESCRIPTION DETAILLEE DE L'INVENTION

Comme dit précédemment, l'invention propose une demi-cellule de pompe de charges comprenant une cellule élémentaire de pompage CE1, telle que montrée à la figure 3a, comprenant :
- une borne d'entrée E agencée pour recevoir une tension d'entrée Vin, une borne d'horloge H agencée pour recevoir un premier signal d'horloge CK1 et une borne de sortie S,
- un premier condensateur C1 comprenant une première borne connectée à la borne d'horloge H et une deuxième borne,
- un premier transistor A1 comprenant une première borne source/drain couplée à la borne d'entrée E, une deuxième borne source/drain et une borne de grille,
- un deuxième transistor A2 comprenant une première borne source/drain couplée à la borne de sortie S de la cellule élémentaire CE1, une deuxième borne source/drain couplée à la borne d'entrée E et une borne de grille couplée à la deuxième borne du premier condensateur C1,
- un troisième transistor A3 comprenant une première borne source/drain couplée à la première borne source/drain du deuxième transistor A2, une deuxième borne source/drain couplée à la borne de grille du deuxième transistor A2 et une borne de grille couplée à la borne d'entrée E, et
- un quatrième transistor A4 comprenant une première borne source/drain couplée à la deuxième borne source/drain du premier transistor A1, une deuxième borne source/drain couplée à la première borne source/drain des deuxième A2 et troisième A3 transistors et une borne de grille couplée à la borne d'entrée E.

La cellule élémentaire CE1 selon l'invention est caractérisée en ce que la borne de grille du premier transistor A1 est couplée à la borne de grille du deuxième transistor A2.

Sur la figure 3a, les premier, deuxième, troisième et quatrième transistors A1, A2, A3, A4 sont des transistors de type PMOS. Ils comprennent chacun une borne de caisson et lesdites bornes de caisson sont couplées ensemble (et sont donc au même potentiel à la deuxième borne source/drain du premier transistor A1.

La cellule élémentaire CE1 se comporte comme un interrupteur commandé. Lorsque le signal d'horloge CK1 appliqué sur sa borne d'horloge H est au potentiel bas, la sortie S de la cellule élémentaire CE1, est reliée à son entrée E. Inversement, lorsque le signal d'horloge CK1 est au potentiel haut, la sortie de la cellule élémentaire, est isolée de son entrée E.

Selon un mode de mise en œuvre, une cellule élémentaire CE1 selon l'invention est utilisée pour réaliser une demi-cellule de pompe de charges (figure 3a) comprenant :
- une cellule élémentaire CE1 conforme à la cellule élémentaire de la figure 3a, comprenant une borne d'horloge H destinée à recevoir un premier signal d'horloge CK1 et une borne de sortie S,
- un deuxième condensateur C2 comprenant une première borne destinée à recevoir un deuxième signal d'horloge CK2 et une deuxième borne,
- un troisième condensateur C3 comprenant une première borne destinée à recevoir un troisième signal d'horloge CK3 et une deuxième borne couplée à la borne de sortie S de la cellule élémentaire CE1,
- un cinquième transistor A5 comprenant une première borne source/drain couplée à une borne de sortie Vout de la demi-cellule PDC, une deuxième borne source/drain couplée à la borne de sortie S de la cellule élémentaire CE1 et une borne de grille couplée à la deuxième borne du deuxième condensateur C2.

La figure 3b montre un ensemble de signaux d'horloge susceptibles d'être utilisés pour commander le circuit de la figure 3a. Les signaux d'horloge CK1, CK2, CK3 sont des signaux périodiques, de même période, et agencés pour prendre deux valeurs, 0 ou Vdd, Vdd étant un potentiel d'alimentation primaire du circuit.

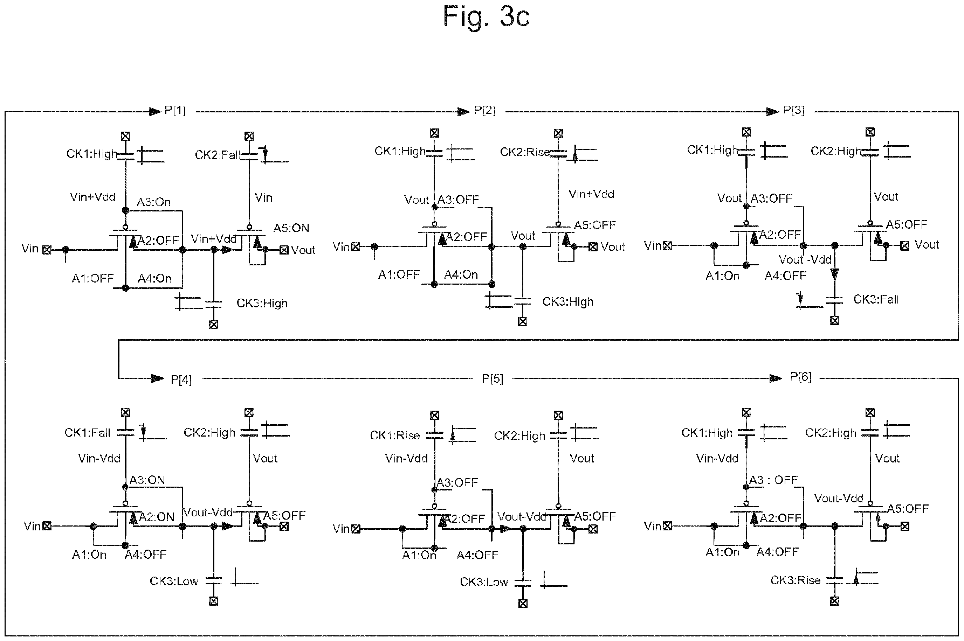

Le fonctionnement de la demi-cellule de pompage de la figure 3a en régime établi va maintenant être décrit en relation avec les figures 3b, 3c.

A un instant t1, le deuxième signal d'horloge CK2 chute de Vdd à 0, rendant ainsi passant le cinquième transistor A5. Le signal CK1 étant au potentiel Vdd, le troisième condensateur C3 a sa première borne au potentiel Vdd et sa deuxième borne au potentiel le plus haut Vin + Vdd de sorte que C3 se décharge en augmentant le potentiel Vout sur la borne de sortie de la demi-cellule PDC pendant une première phase P[1]. Le potentiel sur la deuxième borne du troisième condensateur C3 devient égal à Vout.

A l"instant t2, le deuxième signal d'horloge CK2 grimpe de 0 à Vdd de sorte que le cinquième transistor A5 se bloque. Le troisième condensateur C3 est isolé pendant une deuxième phase P[2].

A l'instant t3, le troisième signal d'horloge CK3 chute de Vdd à 0, entraînant une chute du potentiel sur la deuxième borne du troisième condensateur C3 de Vout à Vout - Vdd pendant une troisième phase P[3], le troisième condensateur C3 restant isolé. Le quatrième transistor A4, précédemment passant, se bloque, et le premier transistor A1, précédemment bloqué, devient passant de sorte que le potentiel de caisson des transistors A1 à A4 passe de Vout à Vin et que la tension source/caisson du transistor A2 diminue.

A l'instant t4, le premier signal d'horloge CK1 chute de Vdd à 0, entraînant une chute de - Vdd sur le potentiel de grille des transistors A2 et A1. A2 devient passant et A1 reste passant. La première borne du troisième condensateur C3 est à un potentiel nul et la deuxième borne du troisième condensateur C3 est reliée à la borne d'entrée E sur laquelle est appliqué le potentiel Vin. Le troisième condensateur C3 se charge pendant une quatrième phase P[4]. Le transistor A3 passant vient renforcer le transfert de charges vers le troisième condensateur C3.

A l'instant t5, le potentiel du premier signal d'horloge grimpe de 0 à Vdd. Les tensions grille/source des transistors A2 et A3 deviennent positives de sorte que les transistors A2 et A3 se bloquent. La tension grille/source du transistor A1 grimpe également de Vdd, mais reste négative de sorte que le transistor A1 reste passant. Le troisième condensateur C3 est isolé pendant une cinquième phase P[5].

A l'instant t6, le troisième signal d'horloge CK3 augmente de 0 à Vdd, entraînant une augmentation du potentiel sur la deuxième borne du troisième condensateur C3 de Vout - Vdd à Vout pendant une sixième phase P[6]. Les transistors A2, A3 et A4 restent bloqués OFF, de même que le transistor A5. Le troisième condensateur C3 reste ainsi isolé.

Les phases P[1] à P[6] sont ensuite répétées de manière cyclique. Les phases P[1] et P[4] correspondent à des phases de transfert de charges. Au cours de la phase P[1], le troisième condensateur C3 se décharge sur la borne de sortie Vout de la demi-cellule PDC puis, au cours de la phase P[4], le troisième condensateur C3 se charge sur la borne d'entrée E de la cellule élémentaire CE1. Les phases P[2], P[3] et P[5], P[6] sont des phases intermédiaires, brèves, assurant la commutation des transistors.

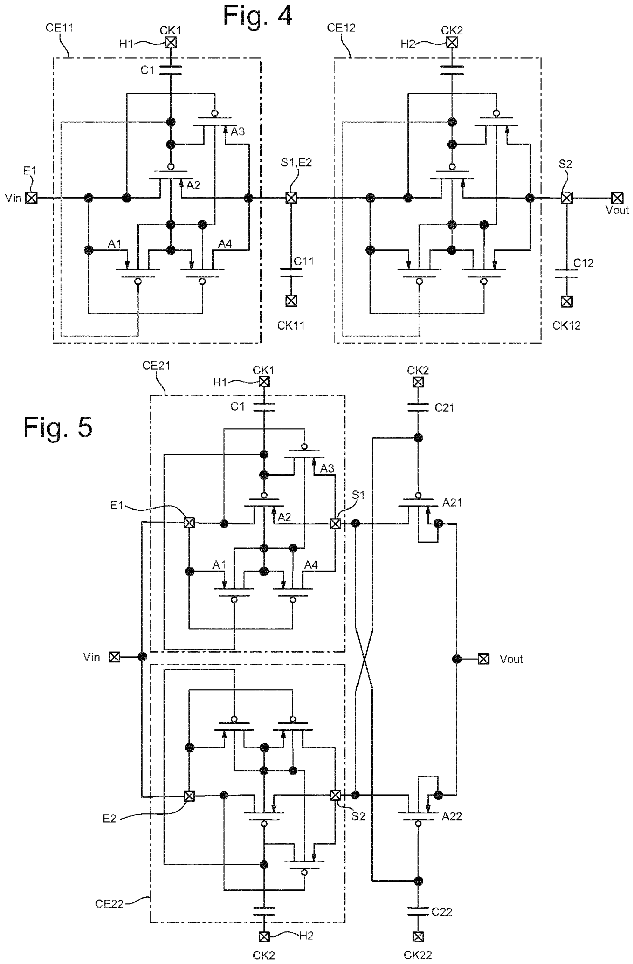

Selon un autre mode de mise en œuvre, une cellule élémentaire selon l'invention est utilisée pour réaliser une pompe de charges de type Dickson (figure 4) comprenant :
- une première cellule élémentaire CE11 et une deuxième cellule élémentaire CE12 réalisées selon l'une des revendications 1 à 3, chaque cellule élémentaire CE11, CE12 comprenant une borne d'entrée E1, E2 une borne d'horloge H1, H2 et une borne de sortie S1, S2, la borne d'entrée E2 de la deuxième cellule élémentaire CE12 étant couplée à la borne de sortie S1 de la première cellule élémentaire CE11,
- un quatrième condensateur C11 comprenant une première borne destinée à recevoir un quatrième signal d'horloge CK11 et une deuxième borne couplée à la borne de sortie S1 de la première cellule élémentaire CE11,
- un cinquième condensateur C12 comprenant une première borne destinée à recevoir un cinquième signal d'horloge CK12 et une deuxième borne couplée à la borne de sortie S2 de la deuxième cellule élémentaire CE12.

La pompe de charges de la figure 4 est ainsi réalisée en associant deux cellules CE11, CE12 élémentaires en série, un condensateur de pompage C11, C12 étant positionné en sortie de chaque cellule élémentaire. Les signaux d'horloge CK1, CK2, CK11, CK12 sont choisis de sorte que :
- au cours d'une première phase, le premier condensateur C11 est chargé et le premier condensateur C12 est déchargé dans un circuit aval (non représenté),
- au cours d'une deuxième phase, le premier condensateur C11 est déchargé dans le premier condensateur C12.

Il est possible d'associer plus de deux cellules élémentaires, pour obtenir un potentiel de sortie Vout supérieur.

Selon encore un autre mode de mise en œuvre, une cellule élémentaire selon l'invention est utilisée pour réaliser une pompe de charges de type à couplage croisé (figure 5) comprenant :
- une première cellule élémentaire CE21 et une deuxième cellule élémentaire CE22 réalisées selon l'une des revendications 1 à 3, chaque cellule élémentaire CE21, CE22 comprenant une borne d'entrée E1, E2, une borne d'horloge H1, H2 et une borne de sortie S1, S2, la borne d'entrée E2 de la deuxième cellule élémentaire CE22 étant couplée à la borne d'entrée E1 de la première cellule élémentaire CE21, la borne d'horloge H1 de la première cellule élémentaire CE21 étant destinée à recevoir un premier signal d'horloge CK1 et la borne d'horloge H2 de la deuxième cellule élémentaire CE22 étant destinée à recevoir un deuxième signal d'horloge CK2,
- un sixième condensateur C21 comprenant une première borne destinée à recevoir un sixième signal d'horloge CK21 et une deuxième borne couplée à la borne de sortie S2 de la deuxième cellule élémentaire CE22,
- un septième condensateur C22 comprenant une première borne destinée à recevoir un septième signal d'horloge CK22 et une deuxième borne couplée à la borne de sortie S1 de la première cellule élémentaire CE21,
- un sixième transistor A21 comprenant une première borne source/drain couplée à une borne de sortie Vout de la pompe de charges de type à couplage croisé, une deuxième borne source/drain couplée à la borne de sortie S1 de la première cellule élémentaire CE21 et une borne de grille couplée à la deuxième borne du sixième condensateur C21,
- un septième transistor A22 comprenant une première borne source/drain couplée à la borne de sortie Vout de la pompe de charges de type à couplage croisé, une deuxième borne source/drain couplée à la borne de sortie S2 de la deuxième cellule élémentaire CE22 et une borne de grille couplée à la deuxième borne du septième condensateur C22.

La pompe de charges de la figure 5 est ainsi réalisée en associant deux cellules CE21, CE22 élémentaires en parallèle, les sorties des cellules élémentaires étant entrecroisées. Les signaux d'horloge CK1, CK2, CK21, CK22 sont choisis de sorte que :
- au cours d'une première phase, la cellule élémentaire CE21 couple le deuxième condensateur C22 au potentiel Vin et la cellule élémentaire CE22 couple le deuxième condensateur C21 au potentiel Vin, les transistors A21 et A22 étant bloqués. Les deuxièmes condensateurs C21 et C22 se chargent, et
- au cours d'une deuxième phase, les condensateurs C21, C22 sont isolés des cellules élémentaires CE21, CE22 et les transistors A21, A22 sont passants. Les condensateurs C21 et C22 se déchargent sur la borne de sortie Vout.

## Revendications

1. Cellule élémentaire de pompage (CE1), comprenant :
- une borne d'entrée (E) agencée pour recevoir une tension d'entrée (Vin), une borne d'horloge (H) agencée pour recevoir un premier signal d'horloge (CK1) et une borne de sortie (S),
- un premier condensateur (C1) comprenant une première borne connectée à la borne d'horloge et une deuxième borne,
- un premier transistor (A1) comprenant une première borne source/drain couplée à la borne d'entrée (E), une deuxième borne source/drain et une borne de grille,
- un deuxième transistor (A2) comprenant une première borne source/drain couplée à la borne de sortie de la cellule élémentaire, une deuxième borne source/drain couplée à la borne d'entrée et une borne de grille couplée à la deuxième borne du premier condensateur (C1),
- un troisième transistor (A3) comprenant une première borne source/drain couplée à la première borne source/drain du deuxième transistor (A2), une deuxième borne source/drain couplée à la borne de grille du deuxième transistor (A2) et une borne de grille couplée à la borne d'entrée, et
- un quatrième transistor (A4) comprenant une première borne source/drain couplée à la deuxième borne source/drain du premier transistor (A1), une deuxième borne source/drain couplée à la première borne source/drain des deuxième (A2) et troisième (A3) transistors et une borne de grille couplée à la borne d'entrée,
la cellule élémentaire étant **caractérisée en ce que** la borne de grille du premier transistor (A1) est couplée directement à la borne de grille du deuxième transistor (A2).

2. Cellule élémentaire selon la revendication 1, dans laquelle les premier, deuxième, troisième et quatrième transistors (A1, A2, A3, A4) comprennent chacun une borne de caisson, lesdites bornes de caisson étant couplées ensemble à la deuxième borne source/drain du premier transistor (A1).

3. Cellule élémentaire selon la revendication 1 ou 2, dans laquelle les premier, deuxième, troisième et quatrième transistors (A1, A2, A3, A4) sont des transistors de même type et de préférence de type PMOS.

4. Demi-cellule de pompe de charges comprenant :
- une cellule élémentaire (CE1) selon l'une des revendications 1 à 3, comprenant une borne d'horloge (H) destinée à recevoir un premier signal d'horloge (CK1) et une borne de sortie (S),
- un deuxième condensateur (C2) comprenant une première borne destinée à recevoir un deuxième signal d'horloge (CK2) et une deuxième borne,
- un troisième condensateur (C3) comprenant une première borne destinée à recevoir un troisième signal d'horloge (CK3) et une deuxième borne couplée à la borne de sortie (S) de la cellule élémentaire (CE1),
- un cinquième transistor (A5) comprenant une première borne source/drain couplée à une borne de sortie (Vout) de la demi-cellule PDC, une deuxième borne source/drain couplée à la borne de sortie (S) de la cellule élémentaire (CE1) et une borne de grille couplée à la deuxième borne du deuxième condensateur (C2).

5. Pompe de charges de type Dickson, comprenant :
- une première cellule élémentaire (CE11) et une deuxième cellule élémentaire (CE12) réalisées selon l'une des revendications 1 à 3, chaque cellule élémentaire (CE11, CE12) comprenant une borne d'entrée (E1, E2), une borne d'horloge (H1, H2) et une borne de sortie (S1, S2), la borne d'entrée (E2) de la deuxième cellule élémentaire (CE12) étant couplée à la borne de sortie (S1) de la première cellule élémentaire (CE11),
- un quatrième condensateur (C11) comprenant une première borne destinée à recevoir un quatrième signal d'horloge (CK11) et une deuxième borne couplée à la borne de sortie (S1) de la première cellule élémentaire (CE11),
- un cinquième condensateur (C12) comprenant une première borne destinée à recevoir un cinquième signal d'horloge (CK12) et une deuxième borne couplée à la borne de sortie (S2) de la deuxième cellule élémentaire (CE12).

6. Pompe de charges de type à couplage croisé, comprenant :
- une première cellule élémentaire (CE21) et une deuxième cellule élémentaire (CE22) réalisées selon l'une des revendications 1 à 3, chaque cellule élémentaire (CE21, CE22) comprenant une borne d'entrée (E1, E2), une borne d'horloge (H1, H2) et une borne de sortie (S1, S2), la borne d'entrée (E2) de la deuxième cellule élémentaire (CE22) étant couplée à la borne d'entrée (E1) de la première cellule élémentaire (CE21), la borne d'horloge (H1) de la première cellule élémentaire (CE21) étant destinée à recevoir un premier signal d'horloge (CK1) et la borne d'horloge (H2) de la deuxième cellule élémentaire (CE22) étant destinée à recevoir un deuxième signal d'horloge (CK2),
- un sixième condensateur (C21) comprenant une première borne destinée à recevoir un sixième signal d'horloge (CK21) et une deuxième borne couplée à la borne de sortie (S2) de la deuxième cellule élémentaire (CE22),
- un septième condensateur (C22) comprenant une première borne destinée à recevoir un septième signal d'horloge (CK22) et une deuxième borne couplée à la borne de sortie (S1) de la première cellule élémentaire (CE21),
- un sixième transistor (A21) comprenant une première borne source/drain couplée à une borne de sortie (Vout) de la pompe de charges de type à couplage croisé, une deuxième borne source/drain couplée à la borne de sortie (S1) de la première cellule élémentaire (CE21) et une borne de grille couplée à la deuxième borne du sixième condensateur (C21),
- un septième transistor (A22) comprenant une première borne source/drain couplée à la borne de sortie (Vout) de la pompe de charges de type à couplage croisé, une deuxième borne source/drain couplée à la borne de sortie (S2) de la deuxième cellule élémentaire (CE22) et une borne de grille couplée à la deuxième borne du septième condensateur (C22).

## Patentansprüche

1. Pump-Elementarzelle (CE1), umfassend:
- eine Eingangsklemme (E), die angeordnet ist, um eine Eingangsspannung (Vin) zu empfangen, eine Großuhrklemme (H), die angeordnet ist, um ein erstes Großuhrsignal (CK1) zu empfangen, und eine Ausgangsklemme (S),
- einen ersten Kondensator (C1), umfassend eine erste Klemme, die mit der Großuhrklemme verbunden ist, und eine zweite Klemme,
- einen ersten Transistor (A1), umfassend eine erste Source/Drain-Klemme, die an die Eingangsklemme (E) gekoppelt ist, eine zweite Source/Drain-Klemme und eine Gitterklemme,
- einen zweiten Transistor (A2), umfassend eine erste Source/Drain-Klemme, die an die Ausgangsklemme der Elementarzelle gekoppelt ist, eine zweite Source/Drain-Klemme, die an die Eingangsklemme gekoppelt ist, und eine Gitterklemme, die an die zweite Klemme des ersten Kondensators (C1) gekoppelt ist,
- einen dritten Transistor (A3), umfassend eine erste Source/Drain-Klemme, die an die erste Source/Drain-Klemme des zweiten Transistors (A2) gekoppelt ist, eine zweite Source/Drain-Klemme, die an die Gitterklemme des zweiten Transistors (A2) gekoppelt ist, und eine Gitterklemme, die an die Eingangsklemme gekoppelt ist, und
- einen vierten Transistor (A4), umfassend eine erste Source/Drain-Klemme, die an die zweite Source/Drain-Klemme des ersten Transistors (A1) gekoppelt ist, eine zweite Source/Drain-Klemme, die an die erste Source/Drain-Klemme des zweiten (A2) und dritten (A3) Transistors gekoppelt ist, und eine Gitterklemme, die an die Eingangsklemme gekoppelt ist,
wobei die Elementarzelle **dadurch gekennzeichnet ist, dass** die Gitterklemme des ersten Transistors (A1) direkt an die Gitterklemme des zweiten Transistors (A2) gekoppelt ist.

2. Elementarzelle nach Anspruch 1, wobei der erste, zweite, dritte und vierte Transistor (A1, A2, A3, A4) jeweils eine Wannenklemme umfassen, wobei die Wannenklemmen zusammen an die zweite Source/Drain-Klemme des ersten Transistors (A1) gekoppelt sind.

3. Elementarzelle nach Anspruch 1 oder 2, wobei der erste, zweite, dritte und vierte Transistor (A1, A2, A3, A4) Transistoren vom gleichen Typ und vorzugsweise vom Typ PMOS sind.

4. Halbzelle einer Ladungspumpe, umfassend:
- eine Elementarzelle (CE1) nach einem der Ansprüche 1 bis 3, umfassend eine Großuhrklemme (H), die dazu bestimmt ist, ein erstes Großuhrsignal (CK1) zu empfangen, und eine Ausgangsklemme (S),
- einen zweiten Kondensator (C2), umfassend eine erste Klemme, die dazu bestimmt ist, ein zweites Großuhrsignal (CK2) zu empfangen, und eine zweite Klemme,
- einen dritten Kondensator (C3), umfassend eine erste Klemme, die dazu bestimmt ist, ein drittes Großuhrsignal (CK3) zu empfangen, und eine zweite Klemme, die an die Ausgangsklemme (S) der Elementarzelle (CE1) gekoppelt ist,
- einen fünften Transistor (A5), umfassend eine erste Source/Drain-Klemme, die an eine Ausgangsklemme (Vout) der PDC-Halbzelle gekoppelt ist, eine zweite Source/Drain-Klemme, die an die Ausgangsklemme (S) der Elementarzelle (CE1) gekoppelt ist, und eine Gitterklemme, die an die zweite Klemme des zweiten Kondensators (C2) gekoppelt ist.

5. Ladungspumpe vom Typ Dickson, umfassend:
- eine erste Elementarzelle (CE11) und eine zweite Elementarzelle (CE12), die nach einem der Ansprüche 1 bis 3 ausgeführt sind, wobei jede Elementarzelle (CE11, CE12) eine Eingangsklemme (E1, E2), eine Großuhrklemme (H1, H2) und eine Ausgangsklemme (S1, S2) umfasst, wobei die Eingangsklemme (E2) der zweiten Elementarzelle (CE12) an die Ausgangsklemme (S1) der ersten Elementarzelle (CE11) gekoppelt ist,
- einen vierten Kondensator (C11), umfassend eine erste Klemme, die dazu bestimmt ist, ein viertes Großuhrsignal (CK11) zu empfangen, und eine zweite Klemme, die an die Ausgangsklemme (S1) der ersten Elementarzelle (CE11) gekoppelt ist,
- einen fünften Kondensator (C12), umfassend eine erste Klemme, die dazu bestimmt ist, ein fünftes Großuhrsignal (CK12) zu empfangen, und eine zweite Klemme, die an die Ausgangsklemme (S2) der zweiten Elementarzelle (CE12) gekoppelt ist.

6. Ladungspumpe vom Typ mit Kreuzkopplung, umfassend:
- eine erste Elementarzelle (CE21) und eine zweite Elementarzelle (CE22), die nach einem der Ansprüche 1 bis 3 ausgeführt sind, wobei jede Elementarzelle (CE21, CE22) eine Eingangsklemme (E1, E2), eine Großuhrklemme (H1, H2) und eine Ausgangsklemme (S1, S2) umfasst, wobei die Eingangsklemme (E2) der zweiten Elementarzelle (CE22) an die Eingangsklemme (E1) der ersten Elementarzelle (CE21) gekoppelt ist, wobei die Großuhrklemme (H1) der ersten Elementarzelle (CE21) dazu bestimmt ist, ein erstes Großuhrsignal (CK1) zu empfangen, und wobei die Großuhrklemme (H2) der zweiten Elementarzelle (CE22) dazu bestimmt ist, ein zweites Großuhrsignal (CK2) zu empfangen,
- einen sechsten Kondensator (C21), umfassend eine erste Klemme, die dazu bestimmt ist, ein sechstes Großuhrsignal (CK21) zu empfangen, und eine zweite Klemme, die an die Ausgangsklemme (S2) der zweiten Elementarzelle (CE22) gekoppelt ist,
- einen siebten Kondensator (C22), umfassend eine erste Klemme, die dazu bestimmt ist, ein siebtes Großuhrsignal (CK22) zu empfangen, und eine zweite Klemme, die an die Ausgangsklemme (S1) der ersten Elementarzelle (CE21) gekoppelt ist,
- einen sechsten Transistor (A21), umfassend eine erste Source/Drain-Klemme, die an eine Ausgangsklemme (Vout) der Ladungspumpe vom Typ mit Kreuzkopplung gekoppelt ist, eine zweite Source/Drain-Klemme, die an die Ausgangsklemme (S1) der ersten Elementarzelle (CE21) gekoppelt ist, und eine Gitterklemme, die an die zweite Klemme des sechsten Kondensators (C21) gekoppelt ist,
- einen siebten Transistor (A22), umfassend eine erste Source/Drain-Klemme, die an die Ausgangsklemme (Vout) der Ladungspumpe vom Typ mit Kreuzkopplung gekoppelt ist, eine zweite Source/Drain-Klemme, die an die Ausgangsklemme (S2) der zweiten Elementarzelle (CE22) gekoppelt ist, und eine Gitterklemme, die an die zweite Klemme des siebten Kondensators (C22) gekoppelt ist.

## Claims

1. Elementary pumping cell (CE1) comprising:
- an input terminal (E) arranged to receive an input voltage (Vin), a clock terminal (H) arranged to receive a first clock signal (CK1) and an output terminal (S),
- a first capacitor (C1) comprising a first terminal connected to the clock terminal and a second terminal,
- a first transistor (A1) comprising a first source/drain terminal coupled to the input terminal (E), a second source/drain terminal and a gate terminal,
- a second transistor (A2) comprising a first source/drain terminal coupled to the output terminal of the elementary cell, a second source/drain terminal coupled to the input terminal and a gate terminal coupled to the second terminal of the first capacitor (C1),
- a third transistor (A3) comprising a first source/drain terminal coupled to the first source/drain terminal of the second transistor (A2), a second source/drain terminal coupled to the gate terminal of the second transistor (A2) and a gate terminal coupled to the input terminal, and
- a fourth transistor (A4) comprising a first source/drain terminal coupled to the second source/drain terminal of the first transistor (A1), a second source/drain terminal coupled to the first source/drain terminal of the second (A2) and third (A3) transistors and a gate terminal coupled to the input terminal,
the elementary cell being **characterized in that** the gate terminal of the first transistor (A1) is directly coupled to the gate terminal of the second transistor (A2).

2. Elementary cell according to claim 1, wherein the first, second, third and fourth transistors (A1, A2, A3, A4) each comprise a well terminal, said well terminals being coupled together at the second source/drain terminal of the first transistor (A1).

3. Elementary cell according to claim 1 or 2, wherein the first, second, third and fourth transistors (A1, A2, A3, A4) are transistors of the same type and preferably of PMOS type.

4. Charge pump half-cell comprising:
- an elementary cell (CE1) according to one of claims 1 to 3, comprising a clock terminal (H) intended to receive a first clock signal (CK1) and an output terminal (S),
- a second capacitor (C2) comprising a first terminal intended to receive a second clock signal (CK2) and a second terminal,
- a third capacitor (C3) comprising a first terminal intended to receive a third clock signal (CK3) and a second terminal coupled to the output terminal (S) of the elementary cell (CE1),
- a fifth transistor (A5) comprising a first source/drain terminal coupled to an output terminal (Vout) of the CP half-cell, a second source/drain terminal coupled to the output terminal (S) of the elementary cell (CE1) and a gate terminal coupled to the second terminal of the second capacitor (C2).

5. Dickson-type charge pump, comprising:
- a first elementary cell (CE11) and a second elementary cell (CE12) produced according to one of claims 1 to 3, each elementary cell (CE11, CE12) comprising an input terminal (E1, E2), a clock terminal (H1, H2) and an output terminal (S1, S2), the input terminal (E2) of the second elementary cell (CE12) being coupled to the output terminal (S1) of the first elementary cell (CE11),
- a fourth capacitor (C11) comprising a first terminal intended to receive a fourth clock signal (CK11) and a second terminal coupled to the output terminal (S1) of the first elementary cell (CE11),
- a fifth capacitor (C12) comprising a first terminal intended to receive a fifth clock signal (CK12) and a second terminal coupled to the output terminal (S2) of the second elementary cell (CE12).

6. Cross-coupled-type charge pump, comprising:
- a first elementary cell (CE21) and a second elementary cell (CE22) produced according to one of claims 1 to 3, each elementary cell (CE21, CE22) comprising an input terminal (E1, E2), a clock terminal (H1, H2) and an output terminal (S1, S2), the input terminal (E2) of the second elementary cell (CE22) being coupled to the input terminal (E1) of the first elementary cell (CE21), the clock terminal (H1) of the first elementary cell (CE21) being intended to receive a first clock signal (CK1) and the clock terminal (H2) of the second elementary cell (CE22) being intended to receive a second clock signal (CK2),
- a sixth capacitor (C21) comprising a first terminal intended to receive a sixth clock signal (CK21) and a second terminal coupled to the output terminal (S2) of the second elementary cell (CE22),
- a seventh capacitor (C22) comprising a first terminal intended to receive a seventh clock signal (CK22) and a second terminal coupled to the output terminal (S1) of the first elementary cell (CE21),
- a sixth transistor (A21) comprising a first source/drain terminal coupled to an output terminal (Vout) of the cross-coupled-type charge pump, a second source/drain terminal coupled to the output terminal (S1) of the first elementary cell (CE21) and a gate terminal coupled to the second terminal of the sixth capacitor (C21),
- a seventh transistor (A22) comprising a first source/drain terminal coupled to the output terminal (Vout) of the cross-coupled-type charge pump, a second source/drain terminal coupled to the output terminal (S2) of the second elementary cell (CE22) and a gate terminal coupled to the second terminal of the seventh capacitor (C22).
